# EUROPEAN PATENT APPLICATION

(11) **EP 2 916 350 A1**
(43) Date of publication of application: **09.09.2015**
(21) Application number: 14157880.7
(22) Date of filing: 05.03.2014
(51) Int. Cl.: H01L 21/67, H01L 21/205, H01L 31/076

(54) **Interleaf structure for a processing apparatus and processing apparatus with interleaf structure**

(71) Applicant: Applied Materials, Inc., Santa Clara, CA 95054 (US)
(72) Inventor: Ries, Florian, 63825 Westerngrund (DE); Hein, Stefan, 63825 Blankenbach (DE); Henrich, Jürgen, 63694 Limeshain (DE); Sauer, Andreas, 63762 Großostheim (DE)
(74) Representative: Zimmermann & Partner Patentanwälte mbB

(57) **Abstract**

An interleaf structure (100; 300; 400) for a processing apparatus (200; 450) is described. The interleaf structure includes a first chamber (110; 310; 410), wherein the first chamber includes at least one first connecting flange device (120; 320; 420) configured to be connectable to the processing apparatus (200; 450); an interleaf unwinding roll (130; 230; 430) and an interleaf winding roll (131; 231; 431) both located in the first chamber (110; 310; 410). When the interleaf unwinding roll (130; 230; 430) unwinds a first interleaf (140; 340; 440) and the interleaf winding roll (131; 231; 431) winds up a second interleaf (141; 341; 441), the first interleaf and the second interleaf are transported through the first connecting flange device (120; 320; 420), particularly in opposite directions. Further, a processing apparatus, the use of a processing apparatus, and a method for providing a processing apparatus are described.

## Description

### TECHNICAL FIELD OF THE INVENTION

Embodiments of the present invention relate to an interleaf structure for a processing apparatus, and a processing apparatus with an interleaf structure. Embodiments of the present invention particularly relate to an interleaf structure for a vacuum processing apparatus and to a vacuum processing apparatus with an interleaf structure, specifically to a processing apparatus for processing flexible substrates having an interleaf structure.

### BACKGROUND OF THE INVENTION

Processing of flexible substrates, such as plastic films or foils, is in high demand in the packaging industry, semiconductor industries and other industries. Processing may consist of coating of a flexible substrate with a desired material, such as a metal, in particular aluminum, semiconductors and dielectric materials, etching and other processing steps conducted on a substrate for the desired applications. Systems performing this task generally include a processing drum, e.g., a cylindrical roller, coupled to a processing system for transporting the substrate, and on which at least a portion of the substrate is processed. Roll-to-roll coating systems can, thereby, provide a high throughput system.

Typically, a process, e.g. a physical vapor deposition (PVD) process, a chemical vapor deposition (CVD) process, and a plasma enhanced chemical vapor deposition (PECVD) process, can be utilized for depositing thin layers of metals which can be coated onto flexible substrates. However, Roll-to-Roll deposition systems are also experiencing a strong increase in demand in the display industry and the photovoltaic (PV) industry. Further, touch panel elements, flexible displays, and flexible PV modules result in an increasing demand of depositing suitable layers in Roll-to-Roll coaters, particularly with low manufacturing costs. However, such devices typically have several layers, which are typically manufactured with CVD processes and particularly also PECVD processes.

However, the substrates being processed may be very sensitive and susceptible for damages, like scratches, which may influence the function of the processed substrate. In the worst case, the damaged substrate cannot be used in a product and has to be thrown away. Therefore, when winding up a processed substrate, an interleaf may be provided for protecting the substrate after processing. Also, the substrate may be protected by an interleaf before being processed, e.g. when being wound on a supply roll. In both cases, the interleaf may be provided between two adjacent substrate layers, such as between two windings on a winding roll.

Providing an interleaf between the substrate layers on a substrate roll may protect the substrate but also has special space requirements and is dependent on the process performed in the process chamber. For instance, for some processes, an interleaf may be useful for protecting the substrate, whereas other processes may not require protecting the substrate with an interleaf. Thus, in the known art, either a processing chamber having an interleaf option is used, which requires more space, but may be used for special processes, or a processing chamber is used, which does not have an interleaf option, which requires less space.

In view of the above, it is an object of the present invention to provide an interleaf structure, a processing apparatus, a method of mounting for providing a processing apparatus, and the use of a processing chamber with interleaf structure which overcome at least some of the problems in the art.

### SUMMARY OF THE INVENTION

In light of the above, an interleaf structure, a processing apparatus, a method for providing a processing apparatus with an interleaf structure, and a use of a processing apparatus having an interleaf structure according to the independent claims are provided. Further aspects, advantages, and features of the present invention are apparent from the dependent claims, the description, and the accompanying drawings.

According to one embodiment, an interleaf structure for a processing apparatus is provided. The interleaf structure includes a first chamber. The first chamber includes at least one first connecting flange device configured to be connectable to the processing apparatus; and an interleaf unwinding roll and an interleaf winding roll both located in the first chamber. When the interleaf unwinding roll unwinds a first interleaf and the interleaf winding roll winds up a second interleaf, the first interleaf and the second interleaf are transported through the first connecting flange device, particularly in opposite directions.

According to another embodiment, a processing apparatus for processing a substrate is provided. The processing apparatus includes a second chamber. The second chamber includes a substrate un-winding roll support for a substrate un-winding roll for delivering the substrate to be processed, and a substrate winding roll support for a substrate winding roll for storing the processed substrate; and at least one second connecting flange device being configured to be connectable to an interleaf structure according to embodiments described herein.

According to a further embodiment, a method for providing a processing apparatus with an interleaf structure is provided. The processing apparatus includes a substrate unwinding roll for the substrate to be processed and a substrate winding roll for a processed substrate. The method includes opening the processing apparatus; and attaching an interleaf structure, especially the first connecting flange device of the interleaf structure, according to embodiments described herein to the processing apparatus.

According to another embodiment, the use of a processing apparatus according to embodiments described herein is provided. The use includes that, when the substrate is unwound from the substrate unwinding roll and wound on the substrate winding roll in the processing apparatus, the first interleaf is un-wound from the interleaf un-winding roll in the interleaf structure and the second interleaf is wound up on the interleaf winding roll in the interleaf structure during operation of the processing apparatus.

Embodiments are also directed at apparatuses for carrying out the disclosed methods and include apparatus parts for performing each described method step. These method steps may be performed by way of hardware components, a computer programmed by appropriate software, by any combination of the two or in any other manner. Furthermore, embodiments according to the invention are also directed at methods by which the described apparatus operates. It includes method steps for carrying out every function of the apparatus.

### BRIEF DESCRIPTION OF THE DRAWINGS

So that the manner in which the above recited features of the present invention can be understood in detail, a more particular description of the invention, briefly summarized above, may be had by reference to embodiments. The accompanying drawings relate to embodiments of the invention and are described in the following:
- Fig. 1a: shows a schematic side view of an interleaf structure according to embodiments described herein;
- Fig. 1b: shows a schematic front view of the interleaf structure shown in Fig. 1a;
- Fig. 1c: shows a schematic back view of the interleaf structure shown in Fig. 1a;
- Fig. 1d: shows a schematic perspective view of the interleaf structure shown in Fig. 1a;
- Fig. 2a: shows a schematic view of an interleaf structure according to embodiments described herein before being connected to a processing apparatus according to embodiments described herein;
- Fig. 2b: shows a schematic view of an interleaf structure according to embodiments described herein being connected to a processing apparatus according to embodiments described herein;
- Fig. 3a: shows a schematic side view of an interleaf structure according to embodiments described herein;
- Fig. 3b: shows a schematic perspective view of the interleaf structure shown in Fig. 3a;
- Fig. 4: shows a schematic view of an interleaf structure according to embodiments described herein being connected to a processing apparatus according to embodiments described herein;
- Fig. 5: shows a schematic view of an interleaf structure according to embodiments described herein;
- Fig. 6: shows a schematic side view of an interleaf structure according to embodiments described herein being connected to a processing apparatus according to embodiments described herein;
- Fig. 7: shows a flowchart of a method for providing a processing apparatus with an interleaf structure according to embodiments described herein;
- Fig. 8: shows a flowchart of the use of a processing apparatus with an interleaf structure according to embodiments described herein.

### DETAILED DESCRIPTION OF EMBODIMENTS

Reference will now be made in detail to the various embodiments of the invention, one or more examples of which are illustrated in the figures. Within the following description of the drawings, the same reference numbers refer to same components. Generally, only the differences with respect to individual embodiments are described. Each example is provided by way of explanation of the invention and is not meant as a limitation of the invention. Further, features illustrated or described as part of one embodiment can be used on or in conjunction with other embodiments to yield yet a further embodiment. It is intended that the description includes such modifications and variations.

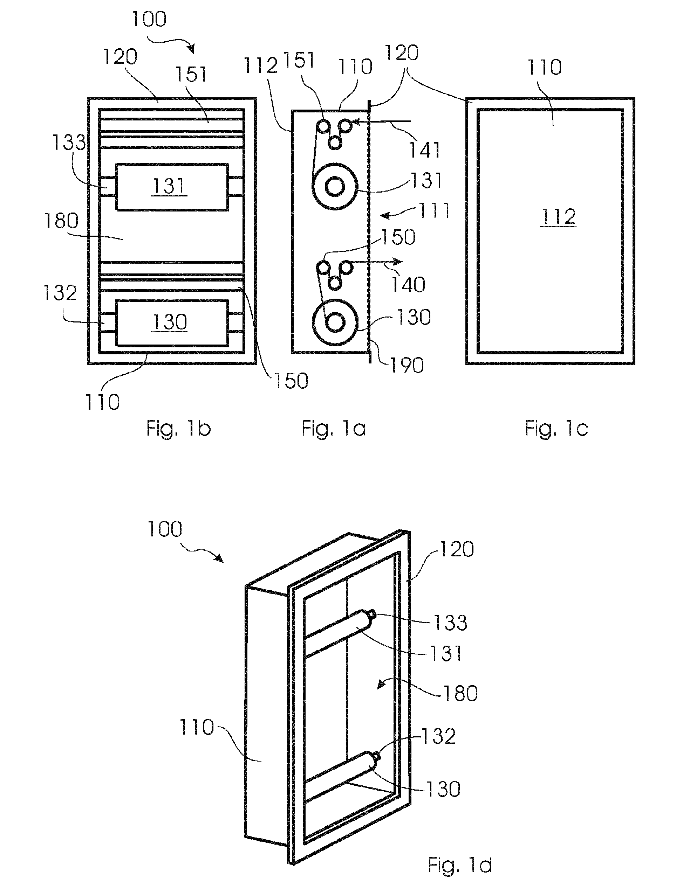

Fig. 1a shows an interleaf structure 100 according to some embodiments described herein. The interleaf structure 100 includes a first chamber 110, an interleaf unwinding roll 130 and an interleaf winding roll 131 in the first chamber 110.

The interleaf unwinding roll 130 as well as the interleaf winding roll 131 are both located in the first chamber 110 of the interleaf structure 100. According to some embodiments, a first interleaf 140 may be unwound from the interleaf unwinding roll 130 (which is indicated by an arrow in Fig. 1a). After being unwound from the unwinding roll 130, the first interleaf 140 is transported through a first connecting flange device 120 of the first chamber 110 of the interleaf structure. According to some embodiments, a second interleaf 141 may be wound up on the interleaf winding roll 131 (which is also indicated by an arrow in Fig. 1a). Before being wound up on the winding roll 131, the first interleaf 141 is also transported through the first connecting flange device 120 of the first chamber 110 of the interleaf structure 100.

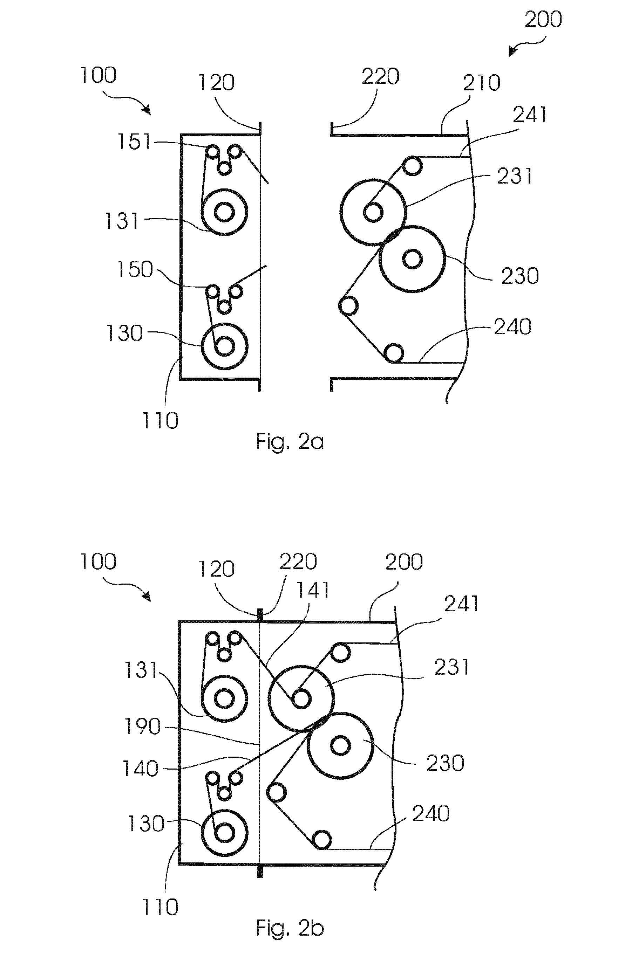

The interleaf structure 100 can be connected to a processing apparatus, e.g. processing apparatus 200 shown in FIGS. 2a and 2b. Thereby, embodiments described herein can provide an optional and/or modular supplement of using an interleaf and/or of using an interleaf structure. Accordingly, an interleaf unwinding roll and/or an interleaf winding roll are typically not provided in a chamber of a processing apparatus, in which the winding roll and/or the unwinding roll for a flexible substrate are provided.

The interleaf unwinding roll may be understood as an interleaf supply roll, which stores an interleaf to be used during processing, especially during winding up of a processed substrate. The interleaf winding roll may be understood as an interleaf take-up roll, which receives a used interleaf, e.g. after un-winding the substrate to be processed from a substrate supply (or un-winding) roll.

Fig. 1b shows a front view of the interleaf structure 100 according to embodiments described herein. The first chamber 110 houses the unwinding roll 130 as well as the winding roll 131. The un-winding roll 130 and the winding roll 131 may be supported in the first chamber 110 by supports 132, 133, respectively. The supports 132 and 133 may be adapted to carry the weight of the winding roll and the unwinding roll during winding and un-winding. The supports of the unwinding and winding roll may be adapted for rotatably supporting the unwinding roll and the winding roll. According to some embodiments, the supports may be fixed within a wall of the first chamber. For instance, the supports for the unwinding roll and the winding roll may be pins located in the chamber wall, bearings in the chamber wall, rotatable gripping devices in the chamber wall, an axle being supported in the chamber wall, and the like. In some embodiments, the supports are adapted for supporting a rotatable winding roll and/or unwinding roll. For instance, the pin, axle, or gripping device acting as a support for the rolls, may be connectable to a drive unit, such as a motor. According to some embodiments, the interleaf structure as described herein may include a drive unit connected to the supports of the winding and/or unwinding roll, or to the winding and/or unwinding roll themselves.

Fig. 1b further shows the first connecting flange device 120 of the connecting flange device of the first chamber 110 of the interleaf structure. The first connecting flange device 120 is shown surrounding the first chamber, in particular around the complete circumference of the first chamber. However, according to some embodiments, a connecting flange as described herein may include several single parts being adapted for connecting the first chamber to a processing chamber. For instance, the connecting flange may consist of a defined number of extensions at each side of the first chamber. The extensions may be intercepted so that the extensions do not form a continuous chamber surrounding flange. According to some embodiments, the connecting flange may include connecting features allowing the first chamber to be connected to a processing chamber by the flange. For instance, the flange may include bores for receiving fixing devices therein, such as screws, bolts, or other detachable connectable devices.

Fig. 1c shows a back view of the interleaf structure 100 shown in Fig. 1a. As can be seen in the embodiments shown in Figs. 1a, 1b and 1c, the first chamber 100 of the interleaf structure is closed at the back side 112 and open at the front side 111. The flange opening 180 at the front side 111 of the first chamber 110 may be understood as a gate for the first interleaf 140 and the second interleaf 141 to enter and exit the first chamber 110. According to some embodiments, the backside 112 of the first chamber 110 may serve for closing the first chamber, especially for closing the housing formed when the first chamber is connected to a processing chamber, as will be explained in detail below.

Fig. 1d shows a perspective view of the interleaf structure 100. In the perspective view, the interleaf unwinding roll 130 and the winding roll 131 can be seen. As discussed above, the chamber 110 is shown having a chamber surrounding first connecting flange device 120 of the connecting flange device. Fig. 1d also shows the support 132 for the unwinding roll 130 and the support 133 for the winding roll 131.

According to embodiments described herein, an interleaf structure for a processing apparatus is described. The interleaf structure includes a first chamber. The first chamber includes at least one first connecting flange device configured to be connectable to the processing apparatus, an interleaf unwinding roll and an interleaf winding roll both located in the first chamber. According to embodiments described herein, a first interleaf and a second interleaf are transported through the first connecting flange device, when the interleaf unwinding roll unwinds the first interleaf and the interleaf winding roll winds up the second interleaf. According to some embodiments, the first interleaf and the second interleaf are transported during winding and unwinding through the first connecting flange device in opposite directions.

A first chamber may be understood as a housing adapted for providing components or elements therein. According to some embodiments, the chamber as described herein may be open at one side, or at both sides (which will be explained in detail below). In some embodiments, the first chamber may include a door for closing at least one of the open sides of the chamber. According to some embodiments, the first chamber as referred to herein may be closeable for vacuum conditions. In one example, the first chamber may be adapted for maintaining vacuum conditions within the first chamber, e.g. when being assembled to a processing apparatus. For instance, the first chamber may provide sealing devices, which allow to close the first chamber vacuum-tight, e.g. when connected to a processing apparatus, or when closing an assembled system including a processing apparatus and an interleaf structure by one or more doors. In one example, the first chamber is equipped with sealing devices by providing sealing devices at the connecting flange device, or the connecting flange.

A connecting flange device as described herein should be understood as a flange device, which may be connected to another element, e.g. a further flange device, a chamber element, a chamber wall, a chamber door, or the like. According to some embodiments described herein, the connecting flange device may include a connecting flange plane and a connecting flange. In one example, the connecting flange may be an element extending from a chamber surface. According to some embodiments described herein, the connecting flange of the connecting flange device may be formed as a (e.g. internal) ridge, a rim, a lip, an extension, and the like, in particular for attachment to another object. According to some embodiments, the connecting flange provides a connecting surface, which serves for connecting the flange with an additional element. According to some embodiments, the connecting surface of the connecting flange may be provided for being in contact with a surface of the additional element (such as a second flange), when the connecting flange is connected to the additional element.

In some embodiments, the connecting flange plane of the connecting flange device may be defined by a plane including (at least partially) the connecting surface of the connecting flange. According to some embodiments, the connecting flange plane may be provided by or include (at least a part of) a vertical cross section of the connecting flange device, or the connecting flange. For instance, the connecting flange device may provide a substantially rectangular cross-section. In some embodiments, the connecting flange plane may be referred to as a connecting plane.

According to some embodiments, the connecting flange device may also provide a flange opening (being e.g. surrounded by the connecting flange), being in particular at least a part of a vertical cross section of the first connecting flange device. According to some embodiments, the opening may be provided in the connecting flange plane. In some embodiments, the flange opening of the connecting flange device may provide a gate surrounded by the connecting flange, which allows substrates to pass through.

In Figs. 1a to 1d, the connecting flange plane can be seen as connecting flange plane 190, through which the first interleaf 140 passes after being unwound from the interleaf unwinding roll 130 and the second interleaf 141 passes before being wound on the interleaf winding roll 131. Also, the flange opening 180 can be seen providing an opening in the flange device, through which the first and the second interleafs can pass.

Fig. 2a shows an interleaf structure 100 and a partial view of a processing apparatus or processing chamber 200. The interleaf structure 100 includes a first chamber 110 and a first connecting flange device 120, which may be designed as described above, especially with respect to Figs. 1a to 1d. The interleaf structure 100 also includes an interleaf unwinding roll 130 and an interleaf winding roll 131 within the first chamber 110 of the interleaf structure 100.

It should be understood that a roll being located within a chamber should be understood as being at least partially or completely surrounded by the chamber. For instance, the chamber may have an open side (such as the front side 111 as shown in Figs 1a to 1c), and surrounds the roll on three sides of the chamber. However, according to some embodiments, the chamber may also surround the roll from four sides, or only from two sides of the chamber.

The processing apparatus 200 includes a second chamber 210 and a second connecting flange device 220 with a second connecting flange and a second connecting flange plane. The second connecting flange device 220 may be adapted for being connected to a first connecting flange device of an interleaf structure according to embodiments described herein. Fig. 2a shows the processing apparatus 200 in an open condition. However, it should be understood that a door of the processing apparatus may be opened or removed, before the processing apparatus 200 is ready to be connected to an interleaf structure according to embodiments described herein.

In some embodiments, the processing apparatus may be a roll-to-roll coating apparatus for coating flexible substrates. The roll-to-roll coating device may be suitable for a coating process and may be equipped accordingly, e.g. with deposition sources. In one example, the processing apparatus is adapted for processing a flexible substrate, which may be a foil or another flexible substrate, such as a web or a glass substrate.

According to some embodiments described herein, the processing apparatus 200 may include some components for performing a process. In the partial view of a processing apparatus 200 shown in Fig. 2a, the processing apparatus 200 includes a substrate unwinding roll 231, which stores a substrate 241 to be processed in the processing apparatus. The substrate 241 is guided in the processing apparatus and processed in a part of the processing apparatus not shown in Fig. 2a. After processing, the processed substrate 240 is guided to a substrate winding roll 230, which stores the processed substrate 240. According to some embodiments, the processing apparatus 200 includes a support for the substrate unwinding roll and a support for the substrate winding roll, which support and carry the substrate winding roll and the substrate unwinding roll during operation.

Fig. 2b shows the interleaf structure 100 and the processing apparatus 200 assembled together. The first connecting flange device 120 of the interleaf structure 100 and the second connecting flange device 220 of the processing apparatus 200 are assembled together and connect the interleaf structure 100 and the processing apparatus 200. According to embodiments described herein, the first connecting flange of the interleaf structure and the second connecting flange of the processing apparatus may correspond to each other in shape so that they may easily be connected with each other. For instance, the first connecting flange and the second connecting flange may include mating surfaces, mating connecting surfaces, mating connecting features, mating bores or holes, a mating size and the like. In some embodiments, the first connecting flange device 120 and the second connecting flange device 220 fix the interleaf structure to the processing apparatus, especially fix the interleaf structure to the processing apparatus in a vacuum tight manner. According to some embodiments, the second connecting flange device may provide an interface of the processing apparatus for the interleaf structure.

As can be seen in Fig. 2b, the processing apparatus 200 houses a substrate unwinding roll 231. The substrate unwinding roll 231 stores the substrate to be processed. The substrate is wound on the substrate unwinding roll 231 in several layers. According to some embodiments, a second interleaf 141 is provided between the layers of the wound substrate on the unwinding roll 231. The second interleaf 141 may serve to protect the substrate before processing, such as protecting the sensitive surface of the substrate to be processed. When the substrate 241 is unwound from the unwinding roll 231, the interleaf 141 provided between the substrate layers on the unwinding roll 231 is unwound from the unwinding roll, too. The unwound interleaf 141 is transported from the processing apparatus 200 through the first connecting flange plane 190 into the interleaf structure 100. In the first chamber 110 of the interleaf structure 100, the second interleaf 141 is wound on the interleaf winding roll 131. The interleaf winding roll 131 may store the interleaf unwound from the substrate unwinding roll 231.

According to some embodiments, the substrate 241 is transported in the processing apparatus 200, of which only parts are shown in Figs. 2a and 2b. The substrate 241 may be subjected to one or more processes, such as deposition processes, heating processes, cooling processes, etching processes, pre-treatment processes, cleaning processes and the like. After being processed, the processed substrate 240 is guided to the substrate winding roll 230 in the processing apparatus 200. The processed substrate 240 is wound to the substrate winding roll 230. Whilst layers of processed substrate are wound onto the substrate winding roll 230, a first interleaf 140 is provided between the layers of wound substrate for protecting the processed substrate 240. According to some embodiments described herein, the first interleaf 140 is unwound from the interleaf unwinding roll 130 in the first chamber 110 of the interleaf structure 100. After being unwound, the first interleaf 140 is transported from the interleaf structure 100 through the first connecting flange plane 190 to the processing apparatus 200. The first interleaf 140 being transported to the processing apparatus is wound on the substrate winding roll 230 together with the processed substrate.

According to some embodiments described herein, the first interleaf 140 may be guided within the first chamber 110 from the un-winding roll 130 by guiding rolls 150. Also, according to some embodiments, the second interleaf 141 may be guided within the first chamber 110 to the winding roll 131 by guiding rolls 151. In some embodiments, the guiding rolls present in the first chamber 110 of the interleaf structure 100 may be adapted for guiding the first interleaf from the interleaf unwinding roll to the substrate winding roll in the processing chamber. Further guiding rolls in the first chamber 110 may be adapted for guiding the second interleaf from the substrate unwinding roll in the processing chamber to the interleaf winding roll in the first chamber of the interleaf structure. Further, the processing apparatus may have guiding rolls for guiding and supporting the transported interleaf. According to some embodiments, the processing apparatus may also have guiding rolls for guiding the substrate from the substrate unwinding roll to the substrate winding roll.

According to some embodiments, the processing apparatus may include additional rolls to the guiding rolls, such as a spreader roller adapted for providing a defined tension for the substrate to be coated; a deflecting roller for deflecting the substrate according to a defined travelling path; a processing roller for supporting the substrate during processing, such as a coating roller or a coating drum; an adjusting roller; or the like. In one embodiment, the surface of the rolls, which is to be in contact with the substrate, may be adapted for the respective substrate to be processed or for the processed substrate.

According to some embodiments, the arrangement of the substrate rolls and further rolls is configured to allow for guiding the substrate without contacting the surface of the substrate to be processed or the processed substrate surface.

In the embodiments shown in the figures, the interleaf winding roll is arranged above the interleaf unwinding roll. According to some embodiments, the arrangement of the interleaf unwinding roll with respect to the interleaf winding roll may depend on the arrangement of the substrate winding roll and the substrate unwinding roll. For instance, if the substrate unwinding roll is arranged above the substrate winding roll, the interleaf winding roll may be arranged above the interleaf unwinding roll. It should be understood that the term being arranged "above" one another or above each other refers to a situation where the rolls are at least partially or totally arranged above each other. For instance, the substrate rolls 230 and 231 in Figs. 2a and 2b are described as being arranged one above the other, although the extension of the substrate rolls in the height direction (vertical direction in the figures) may overlap to a certain extent.

The arrangement of the interleaf rolls above each other may allow for having an uncomplicated and easy design of the interleaf structure being adapted to the arrangement of the substrate rolls. The arrangement of the substrate rolls above one another may also allow for guiding the substrate in a suitable way, while at the same time the processing apparatus may be designed in a compact and space efficient way.

However, although the interleaf winding roll is described and shown in the figures as being arranged over the interleaf unwinding roll, the interleaf rolls may be arranged vice versa.

According to embodiments, the interleaf structure and/or the processing apparatus may be adapted for operating under vacuum conditions. For instance, the processing apparatus may include components and equipment allowing for generating or maintaining a vacuum in at least a part of the processing apparatus. According to some embodiments, the processing apparatus may include vacuum pumps, evacuation ducts, vacuum sealing devices and the like for generating or maintaining a vacuum at least in parts of the processing apparatus. In some embodiments, the processing apparatus may be partitioned in several parts, each of which may include vacuum generating and vacuum maintaining devices for generating and maintaining the vacuum in the single parts independently from the other parts of the processing apparatus. For instance, each part may have its individual corresponding vacuum pump or pumping station for evacuation of the respective area.

According to some embodiments, the processing apparatus being adapted for operating under vacuum conditions forms a vacuum tight enclosure, i.e. can be evacuated to a vacuum with a pressure of about 0.2 to 10 mbar or even to a vacuum with a pressure of 1*10⁻⁴ to 1*10⁻² mbar. Different pressure ranges are to be considered, specifically for PVD processes, in the 10⁻³ mbar - range and CVD in the mbar - range, which are conducted in different pressure regimes. Further, the processing apparatus, or the single parts of the processing apparatus, can be evacuated to a background vacuum with a pressure of 1*10⁻⁶ mbar or below. Background pressure means the pressure which is reached by evacuation of the chamber without any inlet of gases.

According to some embodiments, the first connecting flange device is configured to be connectable to a vacuum processing apparatus. For instance, the first connecting flange may have a defined geometry, which allows for connecting the first connecting flange with a second connecting flange in a vacuum tight manner. In some embodiments, the first connecting flange device and/or the second connecting flange device may include sealing devices suitable for providing a vacuum tight connection between the first connecting flange device and the second connecting flange device. For instance, an elastomeric O-ring gasket can be provided for sealing, such as an O-ring made of a fluoropolymer, silicon rubber or teflon. O-rings can be placed in a groove of the connecting flange or may be used in combination with a centering ring or as a "captured" O-ring that is held in place by separate metal rings. Metal gaskets may be used in ultrahigh vacuum systems where the outgassing of the elastomer could be a significant gas load. Metal wire gaskets made of copper, gold or indium can be used. According to some embodiments, the connecting flange device may be a vacuum flange device and may be connected to another flange by screws, clamping devices, fixing devices and the like, which are suitable for providing sufficient force for sealing a vacuum chamber.

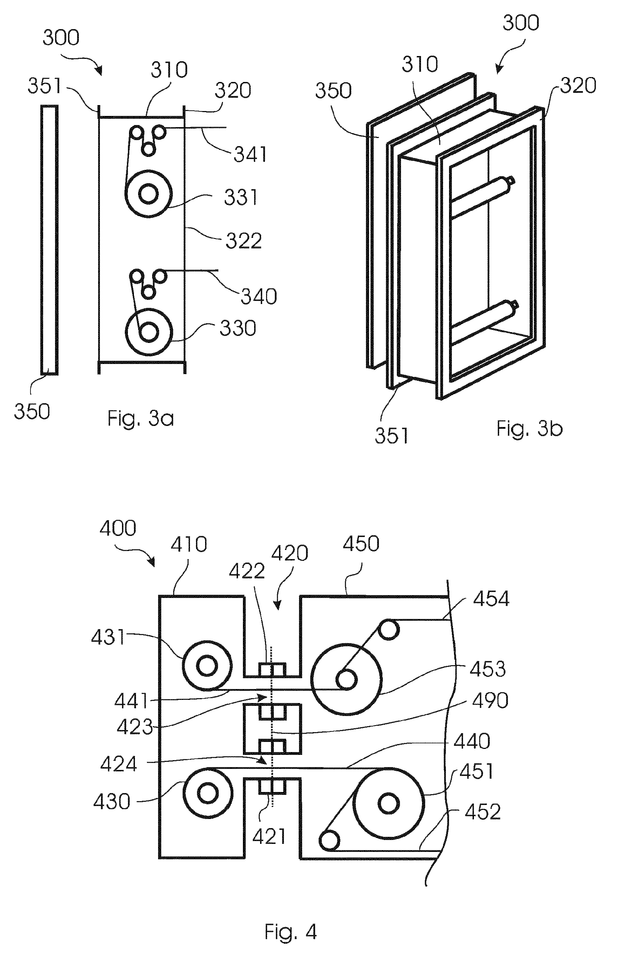

Figs. 3a and 3b show an embodiment of an interleaf structure 300. The interleaf structure 300 includes a first chamber 310 (which may be described as a housing) and a first connecting flange device 320 for connecting the interleaf structure to a processing apparatus, as exemplarily described above. According to some embodiments, the interleaf structure 300 includes a door flange 351, to which a door 350 may be attached for closing the assembled system consisting of interleaf structure and processing apparatus, when the interleaf structure is mounted to the processing apparatus. The chamber 310 further includes a first connecting flange plane 322, through which the first interleaf 340 and the second interleaf 341 may pass, which is indicated in Fig. 3a by the interleafs 340 and 341 running through the first connecting flange plane 322.

The interleaf structure 300 as shown in Figs. 3a and 3b may be provided with the door 350 for easy access and easy mounting of the interleaf structure 300. For instance, if the interleaf unwinding roll 330 is empty and does not provide the first interleaf 340 anymore, the interleaf unwinding roll may be replaced easily and quickly through the door 350. Also, if the interleaf winding roll 331 is complete and is not able to receive more layers of interleaf, the interleaf winding roll 331 may be replaced easily and quickly through the door 350.

According to some embodiments, the door 350 is adapted so that it may close the assembled system consisting of the interleaf structure and processing apparatus in a vacuum tight manner. For instance, as can be seen in Fig. 2a, the processing apparatus 200 is opened for attaching or mounting the interleaf structure. After mounting the interleaf structure to the processing apparatus, the door may allow for holding and maintaining vacuum conditions within the assembled system consisting of interleaf structure and processing apparatus. In one example, the door 350 or the door flange 351 may be configured for keeping vacuum conditions within the assembled system, such as by providing sealings, O-rings, O-rings in a groove, clamping devices for fixing the door to the interleaf structure, screws, further fixing devices and the like.

Fig. 4 shows an embodiment of an interleaf structure 400 including a first chamber 410 and a processing apparatus including a second chamber 450. According to some embodiments, the processing apparatus together with the mounted interleaf structure may be referred to as an assembled system. The interleaf structure 410 includes an interleaf unwinding roll 430, from which the first interleaf 440 is unwound, and an interleaf winding roll 431, on which the second interleaf 441 is wound. According to some embodiments described herein, the first interleaf 440 is transported through a first connecting flange device 420 to the processing apparatus, in particular to a substrate winding roll, on which a processed substrate is wound. The first interleaf 440 protects the processed substrate when being wound on the winding roll 451. A second interleaf 441 is guided from a substrate unwinding roll 453 in the processing apparatus 450, from which a substrate 454 to be processed is wound, through the first connecting flange device 420 to the interleaf winding roll 431 in the interleaf structure 400.

According to some embodiments, which may be combined with other embodiments described herein, the first connecting flange device 420 as shown in Fig. 4 includes one connecting flange for each of the interleafs transported between the interleaf structure and the processing apparatus, e.g. two connecting flanges 421 and 422 and two flange openings 423 and 424. Through each flange opening 423 and 424, one interleaf can pass, e.g. the first interleaf 440 passes through the flange opening 424, and the second interleaf 441 passes through the flange opening 423. The first connecting flange device 420 having two connecting flanges 421 and 422 may include one connecting flange plane 490, through which the first interleaf and the second interleaf are transported, when being moved between the first chamber 410 of the interleaf structure and the second chamber 450 of the processing apparatus. In some embodiments, the connecting flange plane 490 includes (at least partially) the connecting surface of either one of the connecting flanges 421 and 422, or both. According to some embodiments, the connecting flange plane 490 may be described as including at least a part of a vertical cross section of the connecting flange device 420. According to some embodiments, the processing apparatus may provide respective second connecting flange devices for attaching the interleaf structure 410 to the processing apparatus 450.

According to some embodiments, the connecting flange device as referred to herein may have a size being greater than the size of the first chamber of the interleaf structure. For instance, the connecting flange of the connecting flange device may extend from the first chamber of the interleaf structure, as can be seen in the figures. According to some embodiments, the first chamber may have a height of about 3000 mm, a width of about 2000 mm, and a depth of about 500 mm. According to some embodiments described herein, the height of the chamber may typically range from about 2000 mm to about 3500 mm, more typically from about 2500 mm to about 3500 mm, and even more typically from about 2500 mm to about 3200 mm. The width of the first chamber may depend on the width of the substrate (or interleaf) and may typically range from about 1000 mm to about 3500 mm, more typically between about 1200 mm and about 3000 mm, and even more typically between about 1500 mm and about 3000mm. The depth may typically range from about 400 mm and about 800 mm, more typically between about 500 mm and about 800 mm, and even more typically between about 500 mm and about 700 mm. In some embodiments, the connecting flange of the connecting flange device may extend from the chamber by at least 2 cm. According to some embodiments, the connecting flange of the connecting flange device may extend from the first chamber between typically about 2 cm and about 10 cm, more typically between about 3 cm and about 10 cm, and even more typically between about 3 cm and about 8 cm.

In some embodiments, the connecting flange plane of the connecting flange device as described herein may be provided by a cross section of the connecting flange device. According to some embodiments, such as the embodiments shown in Figs. 1 to 3, the connecting flange plane may approximately correspond in size to the cross section of the first chamber. According to some embodiments, the connecting flange plane may have the size of the area surrounded by the connecting flange of the connecting flange device. In some examples, the connecting flange plane of the connecting flange device may have a size between the cross-section of an interleaf and the area surrounded by the connecting flange. As discussed above with respect to Fig. 4, the connecting flange device may include more than one connecting flange opening, each of which having a size sufficient for the interleaf to pass. According to some embodiments, the size of the connecting flange plane, or the flange opening, may be between about 130 cm² (e.g in the case that the flange opening has a width of about 130 cm and a height of about 1 cm) and about 60000 cm² (e.g. in the case that the connecting flange plane corresponds to the cross section of the first chamber).

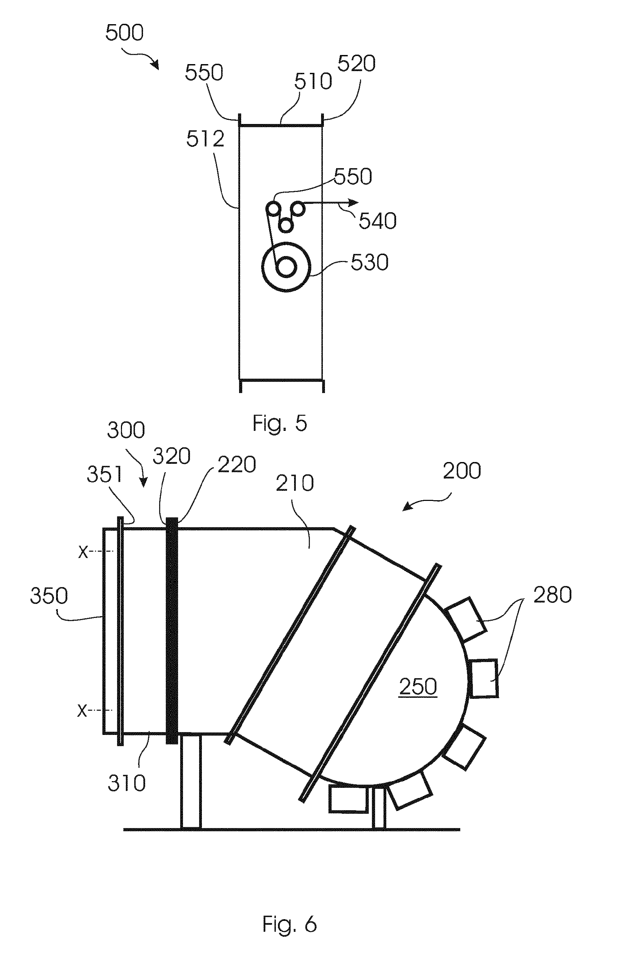

Fig. 5 shows an embodiment of a module 500 for an interleaf structure according to embodiments described herein. The module 500 includes a first chamber 510, a first connecting flange device 520, and an interleaf unwinding roll 530 for unwinding the interleaf 540, which is transported to a processing apparatus (not shown in Fig. 5). Although the unwinding roll 530 is shown in Fig. 5, it should be understood that an interleaf structure as described herein may also include an interleaf winding roll as a single roll in the interleaf structure. The embodiment shown in Fig. 5 may be used if only a protective interleaf is desired for the processed substrate, and not for the substrate to be processed.

According to some embodiments, the interleaf structure as described herein may include more than one module, e.g. the interleaf structure may include two modules like the module 500 shown in Fig. 5 to form the interleaf structure as described herein. In one example, each module may provide an interleaf unwinding roll or an interleaf winding roll. For instance, a first module may be attached to a second module. In one example, the single modules may be provided with module flange devices for interconnecting the modules, such as a module flange device 550 exemplarily shown in Fig. 5. In some embodiments, the module flange device 550 may be suitable for being attached to a door, e.g. in the case that no second module is attached to the first module 500, or in the case that the interleaf structure should be closed in a vacuum tight manner after being connected to the processing apparatus. According to some embodiments, the module may be designed with a closed rear wall, e.g. as the interleaf structure of Fig. 1a to 1d, and may thus be used as an interleaf structure according to embodiments described herein.

The interleaf module allows for providing a high flexibility by assembling together interleaf modules for forming the interleaf structure. The modules may be chosen, adapted, and, e.g. at a later stage, extended for the specific processes desired to be performed in the processing apparatus.

Fig. 6 shows an assembled system including an interleaf structure 300, as previously described in Figs. 3a and 3b and a processing chamber, as exemplarily described in Figs. 2a and 2b. However, it should be understood that the shown interleaf structure and the processing apparatus are only examples and that interleaf structures according to other embodiments described herein may also be used in the assembled system. Generally, Fig. 6 shows a processing apparatus being adapted for connecting an interleaf structure thereon and an interleaf structure being connected thereon.

The interleaf structure 300 shown in Fig. 6 includes a door 350 attached to a door flange 351 of the first chamber of the interleaf structure 300. As exemplarily shown in Fig. 6, the door 350 may be attached to the door flange of the first chamber of the interleaf structure 300 by screws.

The interleaf structure 300 of Fig. 6 is attached to the processing apparatus 200 by a first connecting flange device 320 including the first connecting flange. According to some embodiments, the processing apparatus 200 includes a second chamber 210, which includes a second connecting flange device 220 with the second connecting flange, which mates with the first connecting flange of the interleaf structure 300. In some embodiments, the first connecting flange of the interleaf structure and the second connecting flange of the processing apparatus connect the interleaf structure and the processing apparatus in a vacuum tight manner.

In Figs. 2a and 2b, only a partial view of the processing apparatus 200 is shown. In Fig. 6, an exterior view of the whole processing apparatus 200 is shown. As can be seen in the sectional view of the example shown in Figs. 2a and 2b, the processing apparatus 200 (to which an interleaf structure 300 is connected in Fig. 6) includes a substrate unwinding roll and a substrate winding roll. Also, as described in detail above, the second chamber includes a second connecting flange device 220 having a second connecting flange and a second connecting flange plane, which is, in this example, an area being surrounded by the second connecting flange. When a first interleaf is wound up on the substrate winding roll and a second interleaf is unwound from the substrate unwinding roll, the first interleaf and the second interleaf are transported through the second connecting flange device, particularly in opposite directions. Particularly, the first interleaf and the second interleaf are transported through the second connecting flange plane of the second connecting flange device.

According to some embodiments described herein, both the first interleaf and the second interleaf are transported through the second connecting flange device, in particular the second connecting flange plane, when the interleaf unwinding roll of the interleaf structure unwinds a first interleaf and the interleaf winding roll of the interleaf structure winds up a second interleaf. According to other embodiments, each of the first interleaf and the second interleaf is transported through one flange device, respectively.

In some embodiments, the first connecting flange plane of the interleaf structure and the second connecting flange plane of the processing apparatus are adjacent to each other, contact each other, or even overlap with each other (at least partially), when the interleaf structure is connected to the processing apparatus. According to some embodiments, the interleafs are transported through the first connecting flange plane as well as the second connecting flange plane during operation of a processing apparatus with an interleaf structure as described above.

According to some embodiments described herein, which may be combined with other embodiments described herein, the interleaf may be made from a material having a lesser hardness than the substrate to be processed or the processed substrate, in particular the hardness of the interleaf is less than the hardness of the surface of the substrate. In some embodiments, the interleafs as referred to herein may include a flexible web, such as a polymer web, a paper web, a foil or the like.

The processing apparatus 200 may include a processing chamber part 250, in which a processing roll (e.g. a coating drum) may be located. The substrate may be guided from the substrate unwinding roll in the second chamber of the processing apparatus over guiding rolls to the processing roll and further over guiding rolls to the substrate winding roll. As can be seen in Fig. 6, the processing apparatus 200 may include process equipment, like a deposition source for depositing a material on the substrate, a heating device (such as a heating lamp, e.g. an infrared lamp), cleaning devices, pre-treatment device suchs as devices for preparing the substrate for the process to be performed at a later stage and the like.

In some embodiments, the processing apparatus may be a platform for a variety of processes and PVD processes, such as evaporation or sputtering, or CVD processes, such as a PECVD process, which can be combined while the substrate is moved through the processing apparatus. Particularly, different PECVD processes can be utilized for, e.g., TFT or flexible TFT manufacturing, more particularly for ultrahigh barriers, a microwave plasma process or the like. According to some embodiments, the interleaf structure may be adapted for being connected to process apparatuses performing such processes.

According to some embodiments, an interleaf structure for a processing apparatus is described. The interleaf structure includes a first chamber including at least one first connecting flange device configured to be connectable to the processing apparatus. For instance, the first chamber may include a first connecting flange device as described above, in particular as described with respect to the examples shown in the figures. The interleaf structure according to embodiments described herein may include an (interleaf) unwinding roll support and an (interleaf) winding roll support both located in the first chamber. The unwinding roll support is adapted for receiving and holding an unwinding roll, in particular an interleaf unwinding roll. The winding roll support is adapted for receiving and holding a winding roll, in particular an interleaf winding roll. According to some embodiments, the roll support(s) may be formed as an axle, on which the interleaf rolls may be located during operation, as a bearing, in which or on which the interleaf rolls may be located during operation, as a clamping device, a gripping device, fixtures, carriers, attachment devices, adapter equipment and the like.

According to some embodiments, the chamber as well as and the unwinding roll support and the winding roll support are adapted so that an interleaf being unwound from an unwinding roll at the unwinding roll support and an interleaf being wound on a winding roll at the winding roll support are transported through the first connecting flange device. In particular, the interleafs are transported through the first connecting flange device in opposite directions.

According to embodiments described herein, a method for providing a processing apparatus with an interleaf structure is described. A flowchart of the method 600 is shown in Fig. 6. According to some embodiments described herein, the processing apparatus in the method may be a processing apparatus as described above, especially a processing apparatus as described with respect to Figs. 2a, 2b, and 6. The processing apparatus may include a substrate unwinding roll for the substrate to be processed and a substrate winding roll for a processed substrate. The method 600 includes in block 610 opening the processing apparatus. In some embodiments, the processing apparatus is opened so that the substrate unwinding roll as well as the substrate winding roll, or at least the supports for the substrate winding and unwinding rolls, may be accessed. For instance, the processing apparatus may include a door, which allows accessing both the substrate winding roll and the substrate unwinding roll, or their supports, at the same time. In some embodiments, accessing the winding roll and the unwinding roll of the processing apparatus may include a visual access, a physical or haptic access, a controlling access, and the like.

According to some embodiments, which may be combined with other embodiments described herein, the processing apparatus includes a second chamber, and block 610 may include opening the second chamber of the processing apparatus. Referring back to Fig. 2a, the processing apparatus can be seen with an opened second chamber 210. For instance, a door, a lid, a gate or the like was opened or removed for opening the second chamber of the processing apparatus.

According to embodiments described herein, the method 600 further includes in block 620 attaching an interleaf structure to the processing apparatus. According to some embodiments, the interleaf structure connected to the processing apparatus may be an interleaf structure as described above, in particular as described above with respect to Figs. 1 to 6. Attaching the interleaf structure to the processing apparatus may in particular include connecting the first connecting flange device of the interleaf structure to the second connecting flange device of the processing apparatus.

The method according to some embodiments described herein may further include operating the processing chamber together with the interleaf structure.

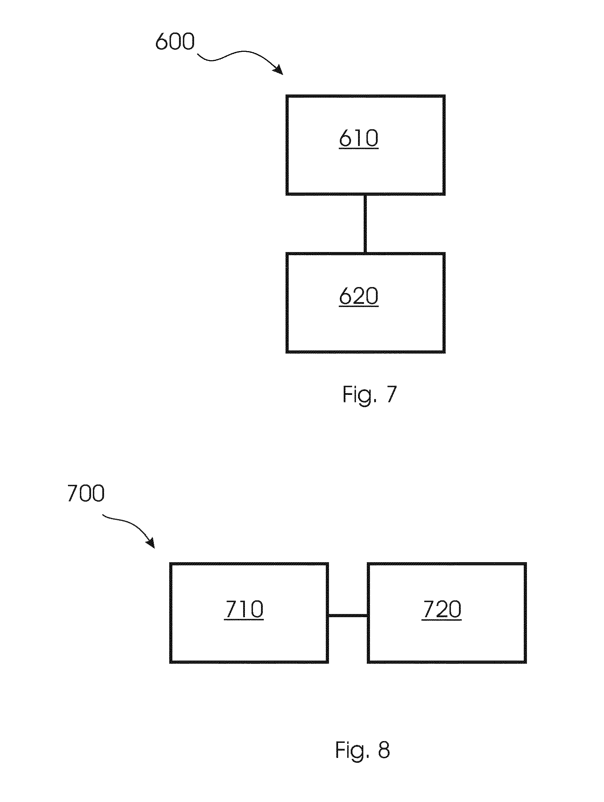

Fig. 8 shows a flow chart of a use 700 of a processing apparatus according to embodiments described herein. According to embodiment described herein, block 710 refers to unwinding the substrate (to be processed) from the substrate unwinding roll and re-winding the (processed) substrate on the substrate winding roll in the processing apparatus. According to some embodiments described herein, at the same time, the first interleaf is un-wound from the interleaf un-winding roll in the interleaf structure and the second interleaf is wound up on the winding roll in the interleaf structure during operation of the processing apparatus.

In some embodiments, the processing apparatus and the interleaf structure used may be as described above, especially with respect to Figs. 1 to 6. According to some embodiments, the processing apparatus and the interleaf structure may be used in a system for depositing material on a flexible substrate, such as in a CVD process, such as a PECVD process. Particularly, the process apparatus and the interleaf structure may be utilized for TFT or flexible TFT manufacturing, more particularly for ultrahigh barriers, a microwave plasma process or the like.

The interleaf structure according to embodiments described herein may be used in a modular manner, i.e. the interleaf structure may be used in case it is desired to have an interleaf function for the processing apparatus. According to some embodiments, the interleaf structure may optionally be provided for a processing apparatus, or may be mounted to the processing apparatus at a later stage, e.g. when the process performed in the processing apparatus changes. Thus, the interleaf structure according to embodiments described herein allows for having a high flexibility regarding changing processes and space requirements for a processing apparatus, while at the same time offering several functions. It should be understood, that, according to some embodiments described herein, the interleaf structure does not include a substrate un-winding roll, a substrate winding roll, a substrate un-winding roll support and/or a substrate winding roll support. By not including a substrate roll (or a substrate roll support), the interleaf structure may be attached to the processing chamber depending on the desired process. The processing apparatus does not provide an interleaf structure unless it is desired and connected thereto.

While the foregoing is directed to embodiments of the invention, other and further embodiments of the invention may be devised without departing from the basic scope thereof, and the scope thereof is determined by the claims that follow.

## Claims

1. An interleaf structure (100; 300; 400) for a processing apparatus (200; 450), comprising:
a first chamber (110; 310; 410), comprising
at least one first connecting flange device (120; 320; 420) configured to be connectable to the processing apparatus (200; 450);
an interleaf unwinding roll (130; 230; 430) and an interleaf winding roll (131; 231; 431) both located in the first chamber (110; 310; 410),
wherein when the interleaf unwinding roll (130; 230; 430) unwinds a first interleaf (140; 340; 440) and the interleaf winding roll (131; 231; 431) winds up a second interleaf (141; 341; 441), the first interleaf and the second interleaf are transported through the first connecting flange device (120; 320; 420), particularly in opposite directions.

2. The interleaf structure according to claim 1, wherein the first connecting flange device (120; 320; 420) is configured to be connectable to a vacuum processing apparatus.

3. The interleaf structure according to any of the preceding claims, wherein the interleaf structure (100; 300; 400) is adapted to be connected to a corresponding interface of a roll-to-roll coating device (200; 450), in which a substrate un-winding roll (231; 453) and a substrate winding roll (230; 451) are arranged, in particular in which the substrate un-winding roll (231; 453) and a substrate winding roll (230; 451) are arranged one above the other.

4. The interleaf structure according to any of the preceding claims, wherein the interleaf winding roll (131; 231; 431) is arranged above the interleaf unwinding roll (130; 230; 430), or vice versa.

5. The interleaf structure according to any of the preceding claims, wherein both the first interleaf (140; 340; 440) and the second interleaf (141; 341; 441) are transported through the first connecting flange device (120; 320; 420), when the interleaf un-winding roll (130; 330; 430) un-winds a first interleaf (140; 340; 440) and the interleaf winding roll (131; 331; 431) winds up a second interleaf (141; 341; 441).

6. The interleaf structure according to any of the preceding claims, wherein the first connecting flange device (120; 320; 420) includes one or more first flange openings (190; 422) being in particular a vertical cross section of the first connecting flange device (120; 320; 420) and/or wherein the first connecting flange device (120; 320; 420) includes a first connecting flange plane (190; 422) being in particular a vertical cross section of the first connecting flange device (120; 320; 420), and
wherein the first interleaf and the second interleaf are transported through the one or more first flange openings and/or the first connecting flange plane.

7. The interleaf structure according to any of the preceding claims, wherein the interleaf structure (100; 300; 400) further comprises guiding rolls (151) for guiding the second interleaf (141; 341; 441) to the interleaf winding roll (131; 331; 431) and/or guiding rolls (150) for guiding the first interleaf (140; 340; 440) from the interleaf unwinding roll (130; 2330; 430).

8. The interleaf structure according to any of the preceding claims, wherein the interleaf structure (100; 300; 400) does not include a substrate un-winding roll (231; 453), a substrate winding roll (230; 451), a substrate un-winding roll support and/or a substrate winding roll support.

9. A processing apparatus (200) for processing a substrate (241; 454), the processing apparatus comprising:
a second chamber (210; 450), comprising
a substrate un-winding roll support for a substrate un-winding roll (231; 453) for delivering the substrate (241; 454) to be processed,
a substrate winding roll support for a substrate winding roll (230; 451) for storing the processed substrate (240; 452), and
at least one second connecting flange device (220) being configured to be connectable to an interleaf structure (100; 300; 400) according to any of claims 1 to 8.

10. The processing apparatus according to claim 9, wherein the second chamber (210; 450) comprises a substrate un-winding roll (231; 453) and a substrate winding roll (230; 451) and wherein, when a first interleaf (140; 440) is wound up on the substrate winding roll (230; 454) and a second interleaf (141; 441) is unwound from the substrate un-winding roll (231; 453), the first interleaf (140; 440) and the second interleaf (141; 441) are transported through the second connecting flange device (220), particularly in opposite directions.

11. The processing chamber according to any of claims 9 to 10, wherein the processing apparatus (200) comprises an interleaf structure (100; 300; 400) according to any of claims 1 to 8.

12. The processing apparatus according to claim 11, wherein both the first interleaf (140; 440) and the second interleaf (141; 441) are transported through the second connecting flange device (220), when the interleaf unwinding roll (130; 330; 430) of the interleaf structure (100; 300; 400) unwinds a first interleaf (140; 440) and the interleaf winding roll (131; 331; 431) of the interleaf structure (100; 300; 400) winds up a second interleaf (141; 441).

13. A method (600) for providing a processing apparatus (200) with an interleaf structure (100; 300; 400), the processing apparatus comprising a substrate unwinding roll (231; 453) for the substrate to be processed (241; 454) and a substrate winding roll (230; 451) for a processed substrate (240; 452), the method comprising:
opening the processing apparatus;
attaching an interleaf structure (100; 300; 400), especially the first connecting flange device (120; 320; 420) of the interleaf structure (100; 300; 400), according to any of claims 1 to 8 to the processing apparatus.

14. The method according to claim 13, wherein opening the processing apparatus includes allowing access to both the substrate unwinding roll (231; 453) and the substrate winding roll (230; 451) in the processing apparatus.

15. Use of a processing apparatus according to any of claims 11 or 12, wherein, when the substrate (240; 453) is un-wound from the substrate unwinding roll (230; 453) and re-wound on the substrate winding roll (230; 451) in the processing apparatus, the first interleaf (140; 30; 440) is un-wound from the interleaf un-winding roll (130; 330; 430) in the interleaf structure (100; 300; 400) and the second interleaf (141; 341; 441) is wound up on the interleaf winding roll (131; 331; 431) in the interleaf structure (100; 300; 400) during operation of the processing apparatus.
